# EUROPEAN PATENT APPLICATION

(11) **EP 4 812 009 A1**
(43) Date of publication of application: **23.09.2026**
(21) Application number: 25225201.0
(22) Date of filing: 18.12.2025
(51) Int. Cl.: H10W 70/63, H05K 1/11

(54) **INTEGRATED CIRCUIT PACKAGES HAVING GROUND PAIRED PARTIAL PAD VERTICAL INTERCONNECT ACCESS**

(30) Priority: 19.03.2025 US 202519083812
(71) Applicant: INTEL Corporation, Santa Clara, CA 95054 (US)
(72) Inventor: SANDESH, Geejagaaru Krishnamurthy, 560037 Bangalore (IN); BALAKRISHNAN, Ranjul, 506048 Bangalore (IN); KAMGAING, Telesphor, Chandler, 85249 (US); KUMAR, Ashwini Anil, 462042 Bhopal (IN); LOGANATHAN, Thangaraj, 641019 Coimbatore (IN)
(74) Representative: 2SPL Patentanwälte PartG mbB

(57) **Abstract**

Disclosed herein is an integrated circuit (IC) substrate having PTH partial via pads, as well as related assemblies, structures, and methods. In some embodiments, an IC substrate may include a first surface and an opposing second surface; a through hole extending from the first surface to the second surface and having a first sidewall portion and an opposing second sidewall portion; a first conductive material, extending between the first and second surfaces, on the first sidewall portion; a second conductive material, extending between the first and second surfaces, on the second sidewall portion; a third conductive material, at the first surface, coupled to the first conductive material and extending outwards; and a fourth conductive material, at the first surface, coupled to the second conductive material and extending outwards, wherein the first and the third conductive materials are physically separated from the second and the fourth conductive materials.

## Description

### Background

Integrated circuit (IC) packages typically include substrates having plated through hole (PTH) vias as vertical interconnect structures to electrically couple components.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1A is a side, cross-sectional view of an example electronic assembly, in accordance with various embodiments.
FIG. 1B is a side, cross-sectional view of another example electronic assembly, in accordance with various embodiments.
FIGS. 2A and 2B are perspective views of example PTH vias with a partial via pad, in accordance with various embodiments.
FIGS. 3A and 3B are perspective views of other example PTH vias with a partial via pad, in accordance with various embodiments.
FIGS. 4A-11A are side, cross-sectional views of an example method of fabricating an example substrate, in accordance with various embodiments.
FIGS. 4B-11B are top views of the example method of fabricating an example substrate of FIGS. 4A-11A, in accordance with various embodiments.
FIGS. 12A-12C are perspective views of other example PTH vias with a partial via pad, in accordance with various embodiments.
FIG. 13A is a top view of a portion of a substrate having PTH vias with partial via pads illustrating routing over void, in accordance with various embodiments.
FIGS. 13B and 13C are top views of a portion of a substrate having PTH vias with partial via pads arranged in grid arrays, in accordance with various embodiments.
FIG. 14 is a perspective view of an example pair of PTH vias having partial via pads, in accordance with various embodiments.
FIGS. 15A and 16A are side, cross-sectional views of an example method of fabricating an example pair of PTH vias having partial via pads in a substrate, in accordance with various embodiments.
FIGS. 15B and 16B are top views of the example method of fabricating an example pair of PTH vias having partial via pads in a substrate of FIGS. 15A and 16A, in accordance with various embodiments.
FIGS. 17A and 18A are side, cross-sectional views of an example method of fabricating another example pair of PTH vias having partial via pads in a substrate, in accordance with various embodiments.
FIGS. 17B and 18B are top views of the example method of fabricating an example pair of PTH vias having partial via pads in a substrate of FIGS. 17A and 18A, in accordance with various embodiments.
FIG. 19 illustrates paired PTH vias and associated spacing requirements in a substrate, in accordance with various embodiments.
FIG. 20 is a cross-sectional view of a device package that includes one or more microelectronic assemblies in accordance with any of the embodiments disclosed herein.
FIG. 21 is a cross-sectional side view of a device assembly that includes one or more microelectronic assemblies in accordance with any of the embodiments disclosed herein.
FIG. 22 is a block diagram of an example computing device that includes one or more microelectronic assemblies in accordance with any of the embodiments disclosed herein.

### Detailed Description

In integrated circuit design and fabrication, the need to improve performance, lower costs, and achieve smaller form factor are constant challenges. Conventional substrates typically include a PTH via that traverses an entire cross-section of a substrate with a via pad attached at one or more surfaces and/or at individual internal layers of the substrate. A conventional via pad is shaped like a flat ring or a donut (e.g., circular with a hole in the center), allowing the center hole to couple to the entire circumference of the PTH via (e.g., a 360 degree circumference). Electrical traces may extend from a via pad coupled to the PTH and may act as an electrical path to electrically couple components on the substrate. In IC design and fabrication, the need to improve performance and reduce costs are constant challenges. For example, vertical interconnect access on a Type-3 core printed circuit board (PCB) structure is typically accomplished using PTH vias.

Many designs using conventional Type-3 PCBs require routing dense parallel bus on a constrained, limited PCB area, which is highly challenging due to dense PTH via placement and resultant via cross talk. In many cases signal traces in the 2F layer (e.g., the layer above the core layer) will be routed over voids due to the larger sized core PTH vias and associated anti-pads on the core layer. Such routing over voids (RoV) usually results in signal integrity issues. These restrictions are likely to result in increased circuit board size, and additional layers to improve the performance. A PCB, as well as other IC substrates, having a vertical interconnect solution that enables dense PTH via placement, reduced RoV, and improved signal integrity may be desired.

Further, in some cases, where the available routing area is sufficiently large, signal PTH via isolation can be achieved by placing 1:1 signal PTH via to ground PTH via ratio to isolate each signal with an associated vertical return path. However, in most cases, especially small form factor designs, the available routing area is not sufficient. A substrate having a vertical interconnect solution with 1:1 signal to ground ratio for small form factor designed also may be desired.

Disclosed herein is an IC substrate having PTH partial via pads, as well as related assemblies, structures, and methods. For example, in some embodiments, an IC substrate may include a first surface and an opposing second surface; a plated through hole (PTH) via extending from the first surface to the second surface, the PTH via having a circumference of 360 degrees; and a via pad, at the first surface, coupled to the PTH via, wherein the via pad extends less than 360 degrees around the circumference of the PTH via. In some embodiments, the via pad may extend 180 degrees or less around the circumference of the PTH via. In some embodiments, the via pad may extend 90 degrees or less around the circumference of the PTH via. In some embodiments, the IC substrate may further include an insulating material in the PTH via.

In other embodiments, an IC substrate may include a first surface and an opposing second surface; a through hole extending from the first surface to the second surface, the through hole having a first sidewall portion and a second sidewall portion opposite the first sidewall portion; a first conductive material, extending between the first surface and the second surface, on the first sidewall portion; a first partial via pad, at the first surface, coupled to the first conductive material; a second conductive material, extending between the first surface and the second surface, on the second sidewall portion; and a second partial via pad, at the first surface, coupled to the second conductive material, wherein the first conductive material and the first partial via pad are physically separated from the second conductive material and the second partial via pad. In some embodiments, the physical separation is an air gap.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies, also referred to herein as semiconductor devices, disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

The terms "substrate" and "IC substrate" as used herein are synonymous. In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material includes interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers). A package substrate may be electrically coupled to a circuit board and include conductive pathways (e.g., conductive traces and/or conductive vias) through which power, ground, and/or signals may be transmitted between the circuit board and semiconductor dies and/or other electrical components.

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed on, over, or under another layer may be directly in contact with the other layer or may have one or more intervening layers. Moreover, one layer disposed between two layers may be directly in contact with one or both of the two layers or may have one or more intervening layers. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

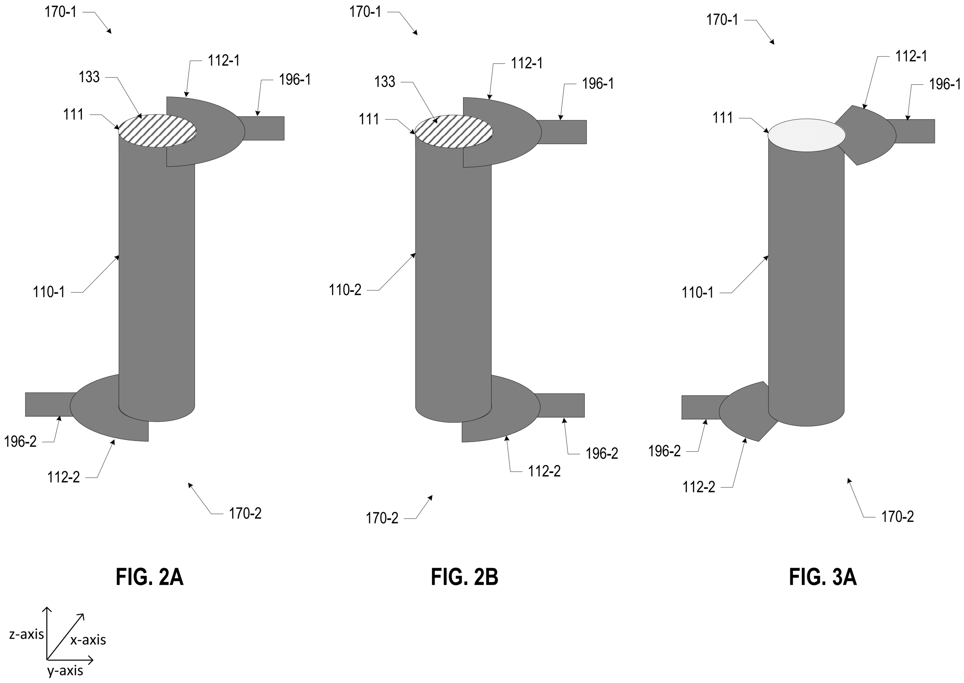

For convenience, if a collection of drawings designated with different letters are present (e.g., FIGS. 2A and 2B), such a collection may be referred to herein without the letters (e.g., as "FIG. 2"). Similarly, if a collection of reference numerals designated with different numbers are present (e.g., 110-1, 110-2), such a collection may be referred to herein without the numbers (e.g., as "110").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

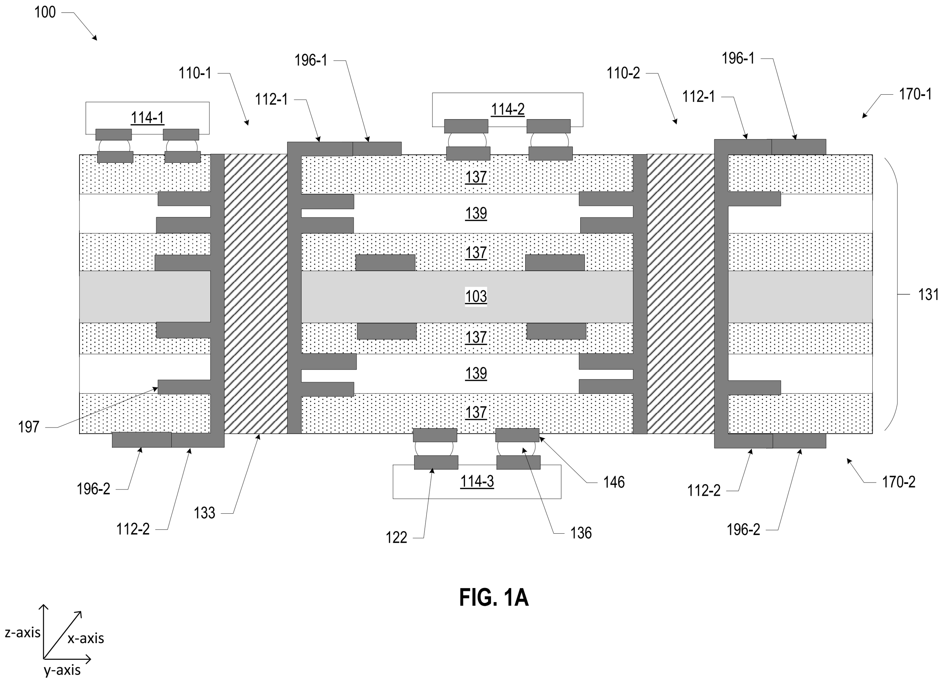

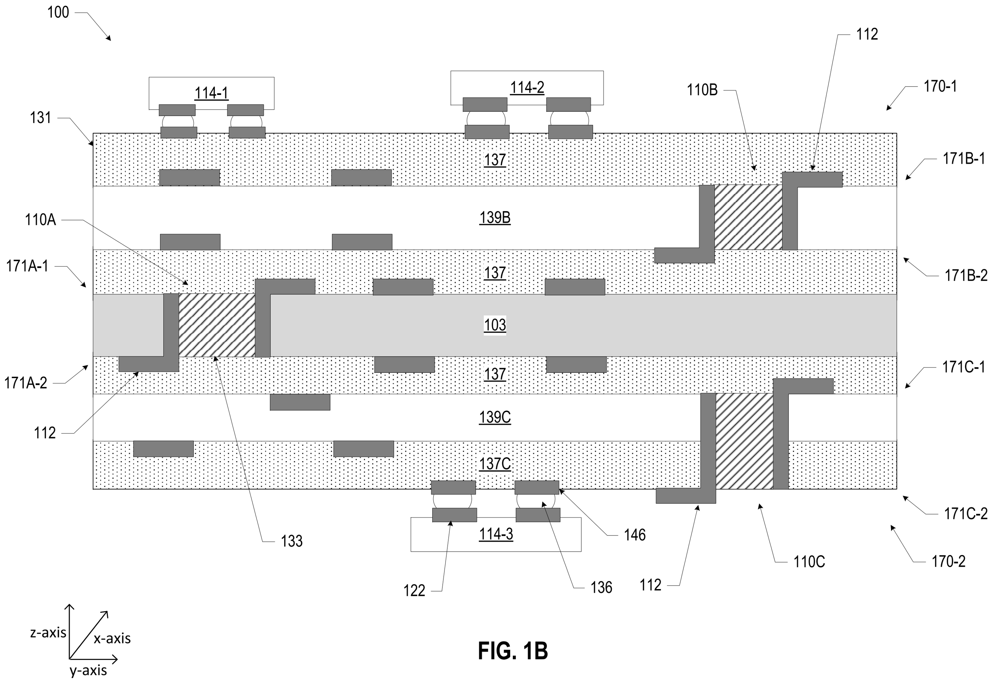

FIG. 1A is a side, cross-sectional view of an example electronic assembly, in accordance with various embodiments. The electronic assembly 100 may include an IC substrate 131 having a first surface 170-1 and an opposing second surface 170-2, a plated through hole (PTH) via 110 (e.g., a first PTH via 110-1 and a second PTH via 110-2) extending from the first surface 170-1 to the second surface 170-2; and a semiconductor device 114 coupled to a surface 170 of the IC substrate 131. As shown in FIG. 1A, a first surface 170-1 may be a first major surface of the IC substrate 131 and the second surface 170-2 may be an opposing second major surface of the IC substrate 131, where the first and second PTH vias 110-1, 110-2 extend the entire thickness of the IC substrate 131 (e.g., from the first major surface to the second major surface). In some embodiments, as shown in FIG. 1B, the first PTH via 110-1 and/or the second PTH via 110-2 may not extend an entire thickness of the IC substrate 131. As used herein, a PTH via 110 may include a through hole with sidewalls having a continuous conductive material extending from the first surface 170-1 to the second surface 170-2, where the through hole has a circumference of 360 degrees and the conductive material is deposited using a technique that is not plated. Further, as used herein, a conductive via pad 112 may include a conductive material, at the first surface, coupled to the conductive material in the through hole, that extends outwards from the through hole and that extends a first distance around the circumference of the through hole, where the first distance is less than the circumference of the through hole, and another conductive via pad 112 may include a conductive material, at the second surface, coupled to the conductive material in the through hole, that extends outwards from the through hole and that extends a second distance around the circumference of the through hole, where the second distance is less than the circumference of the through hole and is different than the first distance.

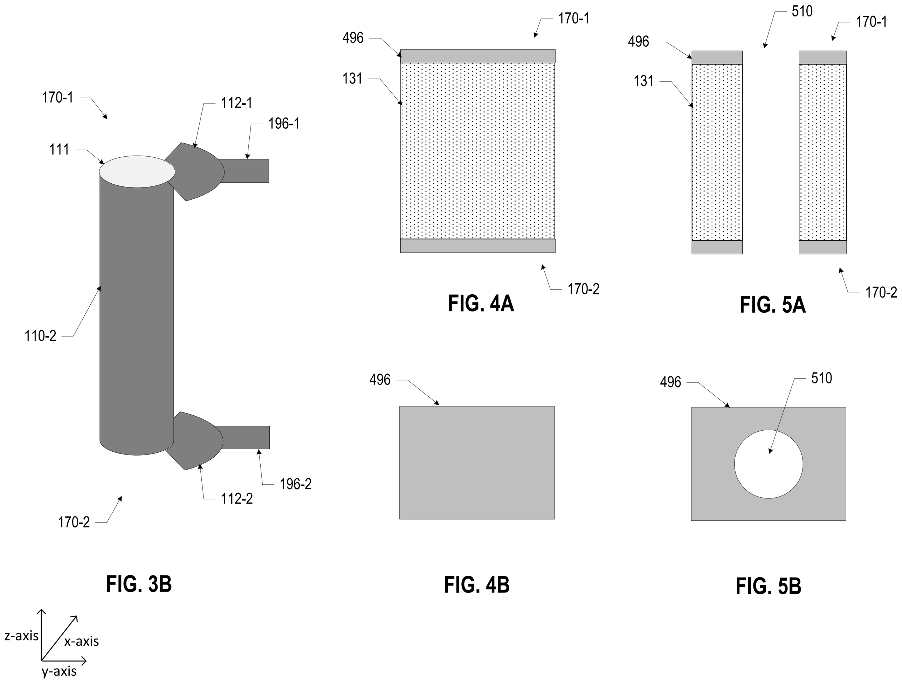

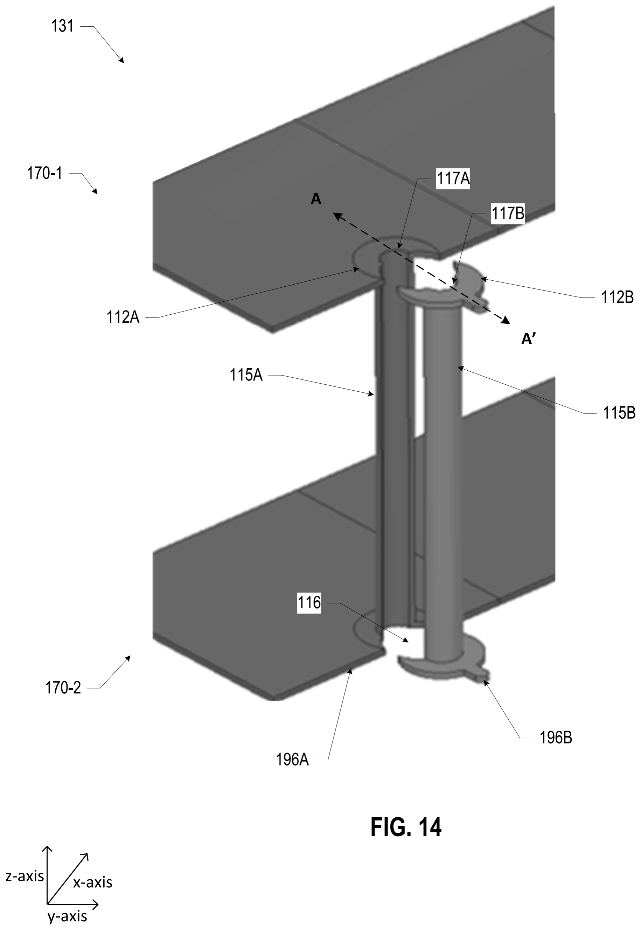

FIGS. 2A and 2B are perspective views of example PTH vias with a partial via pad, in accordance with various embodiments. In particular, as shown in FIG. 2A and 2B, a PTH via 110 may have a circumference 111 of 360 degrees and a first partial via pad 112-1 may be coupled to the PTH via 110 at a first surface 170-1 and a second partial via pad 112-2 may be coupled to the PTH via 110 at a second surface 170-2. A partial via pad 112 may extend less than 360 degrees around the circumference 111 of the PTH via 110. In some embodiments, for example, as shown in FIGS. 2A and 2B, a partial via pad 112 may extend 180 degrees or less around the circumference 111 of the PTH via 110. A first signal trace 196-1 may be coupled to the first partial via pad 112-1 and a second signal trace 196-2 may be coupled to the second partial via pad 112-2. In some embodiments, as shown in FIG. 2A, a first partial via pad 112-1 may extend in a first direction and the second partial via pad 112-2 may extend in a second direction different than or, as shown, opposite from the first direction. In such embodiments, the first signal trace 196-1 may extend in the first direction and the second signal trace 196-2 may extend in the second direction. In some embodiments, as shown in FIG. 2B, a first partial via pad 112-1 and a second partial via pad 112-2 may extend in a same direction, such that the first partial via pad 112-1 at least partially overlaps the second partial via pad 112-2 (e.g., along a z-dimension or in vertical direction). In such embodiments, the first signal trace 196-1 and the second signal trace 196-2 may extend in a same direction. In some embodiments, the first signal trace 196-1 and/or the second signal trace 196-2 may be omitted. In some embodiments, a partial via pad 112 may be coupled to a plane, such as a ground plane, as shown in FIG. 14. The PTH vias 110 and partial via pads 112 may be formed of any suitable conductive material, such as copper, silver, nickel, gold, aluminum, or other metals or alloys, for example. A PTH via 110 may further include an insulating material 133 in the PTH via 110. An insulating material 133 may include any suitable material, such as an epoxy material, a mold material, or a resin material. The insulating material 133 may function to protect the conductive material of the PTH via 110 during manufacturing, as described below with reference to FIGS. 4-11. In some embodiments, an insulating material 133 may include a sacrificial material that is removed subsequent to manufacturing such that the insulating material 133 is omitted from the PTH via 110 (e.g., as shown in FIGS. 3A and 3B).

Returning to FIG. 1A, an IC substrate 131 may include a circuit board, such as a PCB, or a package substrate. In some embodiments, an IC substrate 131 may include a core 103 and a plurality of material layers 137, 139 with conductive pathways 197 on a top surface and a bottom surface of the core 103. In some embodiments, a material of the core 103 may include any suitable material, such as glass, copper clad laminate (CCL), ceramic, or silicon. In some embodiments, a core 103 may be omitted. Although FIG. 1A shows a particular number of layers 137, 139 and cores 103, an IC substrate 131 may have any suitable number and arrangement of layers 137, 139, and cores 103. Conductive pathways 197 may include any suitable conductive routing features, such as traces, vias, and planes. In some embodiments, an IC substrate 131 may include a PCB having multiple metal layers separated from one another by layers of dielectric material (e.g., pre-impregnated material layers) and interconnected by electrically conductive pathways 197. In some embodiments, an IC substrate 131 may include a packages substrate having buildup layers with conductive pathways 197. Any one or more of the metal layers may be formed in a desired circuit pattern to route electrical signals (optionally in conjunction with other metal layers) between the semiconductor devices 114 coupled to IC substrate 131.

An electronic assembly 100 may include semiconductor devices 114-1, 114-2 coupled to a first surface 170-1 of the IC substrate 131 and semiconductor device 114-3 coupled to a second surface 170-2 of the IC substrate 131. The semiconductor devices 114 may be coupled to the IC substrate 131 by interconnects 136. In some embodiments, as shown, interconnects 136 may include coupling conductive contacts 122 on the semiconductor device 114 to conductive contacts 146 on the IC substrate 131. In some embodiments, interconnects 136 may include solder balls for a ball grid array arrangement, as shown, pins in a pin grid array arrangement, lands in a land grid array arrangement, wire bonds, and/or any other suitable electrical and/or mechanical coupling structure. In some embodiments, semiconductor devices 114 may include, but are not limited to, a microprocessor (e.g., central processing unit, system on chip), capacitors, decoupling capacitors, resistors, inductors, fuses, diodes, transformers, sensors, power delivery inductors, electrostatic discharge (ESD) devices, storage (e.g., SSD), and memory devices (e.g., dynamic random access memory (DRAM)). For example, semiconductor device 114-1 may include a microprocessor and semiconductor devices 114-2, 114-3 may include 128-bit DRAM.

Many of the elements of the electronic assembly 100 of FIG. 1A are included in other ones of the accompanying drawings; the discussion of these elements is not repeated when discussing these drawings, and any of these elements may take any of the forms disclosed herein. Further, a number of elements are illustrated in FIG. 1A as included in the electronic assembly 100, but a number of these elements may not be present in an electronic assembly 100.

FIG. 1B is a side, cross-sectional view of another example electronic assembly, in accordance with various embodiments. The embodiment shown in the figure is similar to that of FIG. 1A except that the PTH vias 110 that only extend partially through a thickness (e.g., z-dimension) of the IC substrate 131. In particular, as shown in FIG. 1B, an electronic assembly 100 may include a PTH via 110A extending through the core 103 (e.g., from a first surface 171A-1 to an opposing second surface 171A-2 of the core 103) of the IC substrate 131, a PTH via 110B extending through a single internal layer 139B of the IC substrate 131 (e.g., from a first internal surface 171B-1 to an opposing second internal surface 171B-2), and a PTH via 110C extending through multiple layers 139C, 137C of the IC substrate 131 (e.g., from a first internal surface 171C-1 to an opposing surface 171C-2). Although FIG. 1B shows a particular number and arrangement of PTH vias 110, an IC substrate 131 may have any suitable number and arrangement of PTH vias 110, and the PTH vias 110 may span any number of layers.

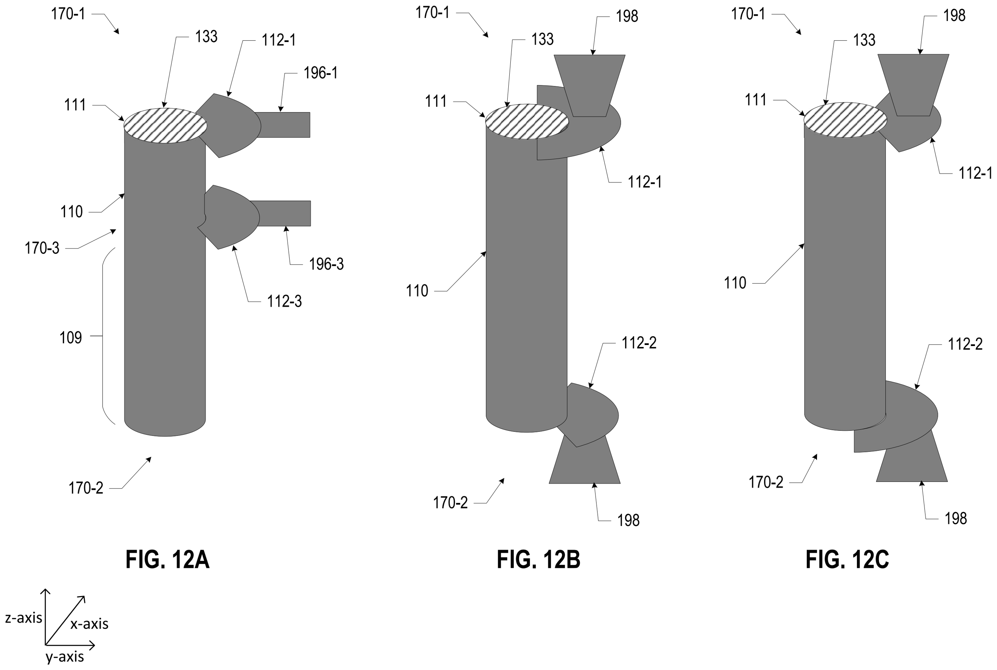

FIGS. 3A and 3B are perspective views of other example PTH vias with a partial via pad, in accordance with various embodiments. The embodiments shown in the figures are similar to that of FIGS. 2A and 2B, respectively, except that a partial via pad 112 may extend 90 degrees or less around the circumference 111 of the PTH via 110 and the PTH via 110 is an aperture or opening (e.g., does not include an insulating material 133, as shown in FIGS. 2A and 2B). Although FIGS. 2A and 2B and FIGS. 3A and 3B illustrate a first partial via pad 112-1 and a second partial via pad 112-2 having the same dimensions, in some embodiments, a first partial via pad 112-1 may extend a first distance around the circumference 111 of the PTH via 110 and a second partial via pad 112-2 may extend a second distance around the circumference 111 of the PTH via 110, where the first distance and the second distance are less than the circumference 111 of the PTH via 110 and the second distance is different than the first distance. For example, a first partial via pad 112-1 may extend 180 degrees or less around the circumference 111 of the PTH via 110 and a second partial via pad 112-2 may extend 90 degrees or less around the circumference 111 of the PTH via 110 (e.g., as shown in FIG. 12B), or vice versa (e.g., as shown in FIG. 12C).

Any suitable techniques may be used to manufacture the electronic assemblies 100 disclosed herein. Although the operations discussed below with reference to FIGS. 4-11 are illustrated in a particular order, these operations may be performed in any suitable order. Further, additional operations which are not illustrated may also be performed without departing from the scope of the present disclosure. Also, various ones of the operations discussed herein with respect to FIGS. 4-11 may be modified in accordance with the present disclosure to fabricate others of electronic assembly 100 disclosed herein.

FIGS. 4A-11A are side, cross-sectional views and FIGS. 4B-11B are associated top views of an example method of fabricating an example IC substrate, in accordance with various embodiments.

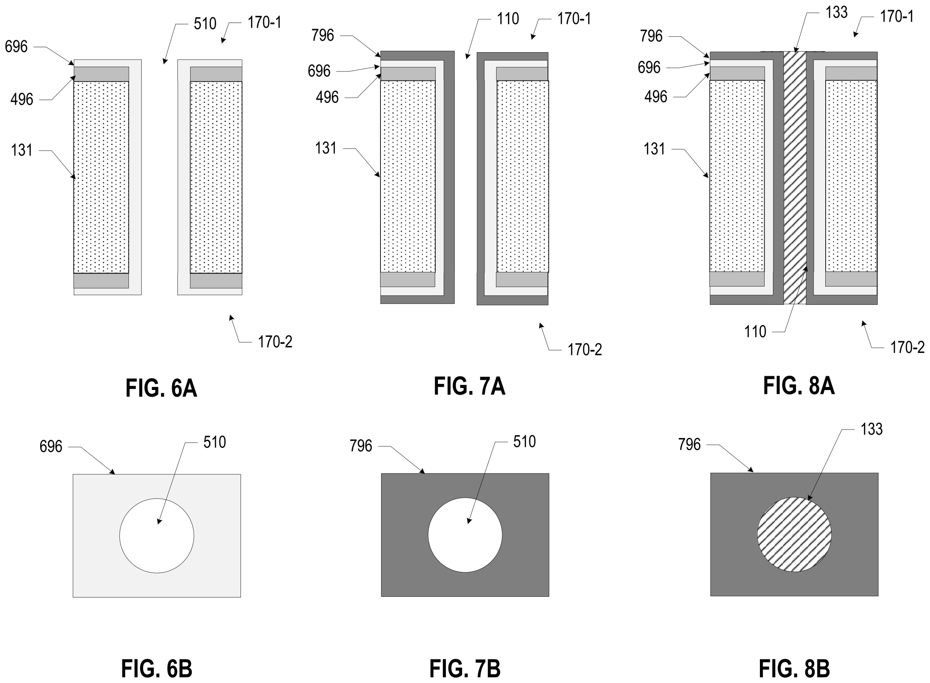

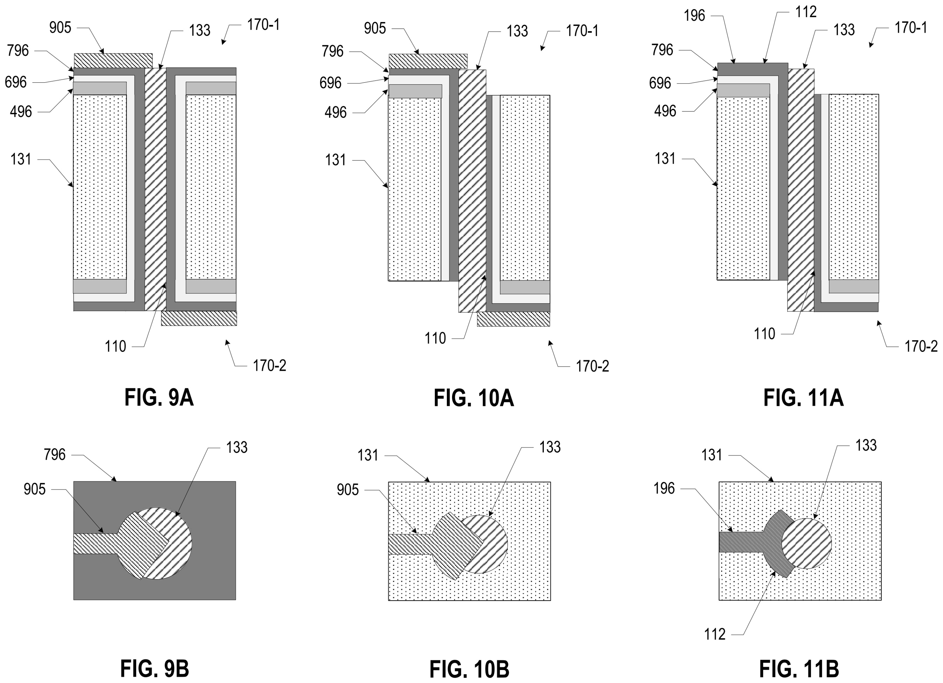

FIGS. 4A and 4B illustrate an assembly including an IC substrate 131 with a metal layer 496 on a first surface 170-1 and an opposing second surface 170-2. In some embodiments, an IC substrate 131 may include multiple internal layers that are etched and stacked. In some embodiments, an IC substrate 131 may include multiple internal layers on top and bottom surfaces of a core (e.g., as shown in FIG. 1). A metal layer 496 may include any suitable metal, such as copper, and may be deposited using any suitable technique, such as lamination. In some embodiments, a metal layer 496 may include a copper clad material. FIGS. 5A and 5B illustrate an assembly subsequent to forming a through hole 510 in the assembly of FIGS. 4A and 4B. The through hole 510 may be formed using any suitable technique, such as mechanical drilling. FIGS. 6A and 6B illustrate an assembly subsequent to plating the assembly of FIGS. 5A and 5B with a metal layer 696. The metal layer 696 may include any suitable metal, such as copper, and may be deposited using any suitable technique, such as electroless copper plating. FIGS. 7A and 7B illustrate an assembly subsequent to plating the assembly of FIGS. 6A and 6B with a metal layer 796. The metal layer 796 may include any suitable metal, such as copper, and may be deposited using any suitable technique, such as electrolysis copper plating. The metal layers 696, 796 in through hole 510 may form PTH via 110. FIGS. 8A and 8B illustrate an assembly subsequent to depositing an insulating material 133 in the PTH via 110. The insulating material 133 may include any suitable material, as described above with reference to FIG. 2. In some embodiments, the insulating material 133 may include a sacrificial material that is deposited during manufacturing to protect the metal layers 696, 796 in the PTH via 110 from degradation or removal, and subsequently removed at the end of the manufacturing process. A sacrificial material may include any suitable material that can be selectively removed, such as a sacrificial polymer. FIGS. 9A and 9B illustrate an assembly subsequent to depositing a screen film 905 on portions of the assembly of FIGS. 8A and 8B to protect the metal layers from removal. As shown in FIG. 9B, the screen film 905 may be shaped to form a partial via pad 112 and a signal trace 196 as shown in FIG. 11. FIGS. 10A and 10B illustrate an assembly subsequent to etching metal layers 496, 696, 796 from portions not covered by the screen film 905. FIGS. 11A and 11B illustrate an assembly subsequent to removing the screen film 905 and cleaning the assembly, where the assembly includes a partial via pad 112 coupled to a PTH via 110 and a signal trace 196 coupled to the partial via pad 112.

FIG. 12A is a perspective view of another example PTH vias with a partial via pad, in accordance with various embodiments. The embodiment shown in the figure is similar to that of FIG. 3B except that the partial via pad 112-3 is at a third surface 170-3 between the first surface 170-1 and the second surface 170-2, and the PTH via 110 does not include a second partial via pad 112-2 at the second surface and includes an insulating material 133. The signaling portion of the PTH via 110, as shown in FIG. 12A, extends less than the entire length of the PTH via 110, where the remaining unintended signaling portion is a stub portion 109. Signal traces 196-1, 196-3 may interconnect a transition between a surface 170-1 and an internal layer 170-3 or between two internal layers; the closer the internal routing layer 170-3 is to the surface 170-1, the longer the stub portion 109 will be.

FIGS. 12B and 12C are perspective views of other example PTH vias with a partial via pad, in accordance with various embodiments. The embodiments shown in the figures are similar to that of FIGS. 2A and 2B, respectively, except that a first surface 170-1 and a second surface 170-2 may be surfaces 170 of a core 103 of a IC substrate 131, and a partial via pad 112 may couple to a via 197 (e.g., to a conductive pathway 197 in the IC substrate 131 instead of a signal trace 196). Further, as described above, a first partial via pad 112-1 may extend 180 degrees or less around the circumference 111 of the PTH via 110 and a second partial via pad 112-2 may extend 90 degrees or less around the circumference 111 of the PTH via 110 (e.g., as shown in FIG. 12B), or vice versa (e.g., as shown in FIG. 12C).

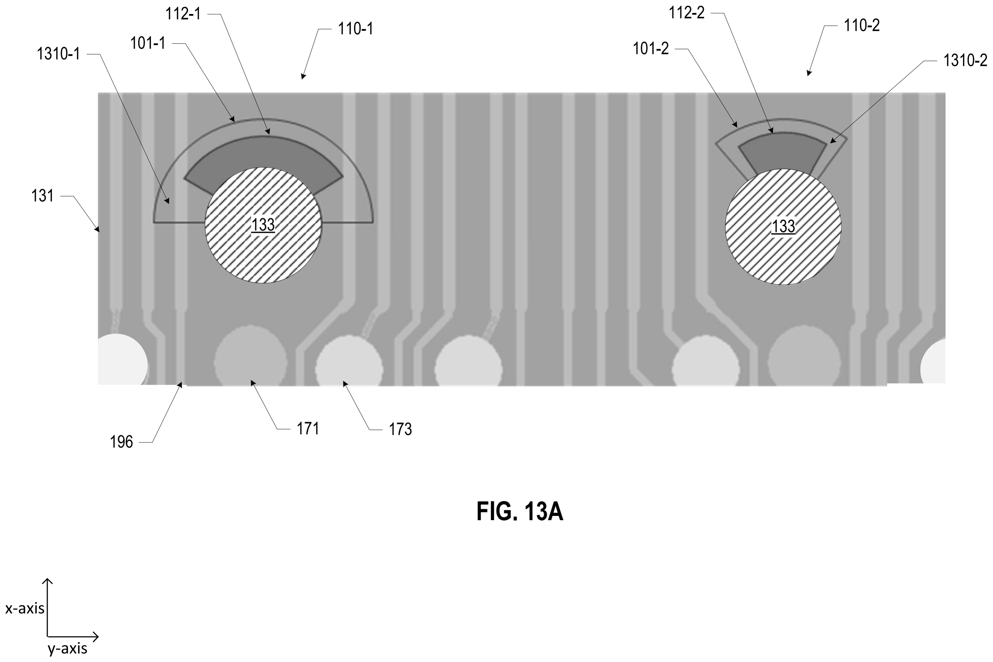

FIG. 13A is a top view of a portion of an IC substrate having PTH vias with partial via pads illustrating routing over void, in accordance with various embodiments. FIG. 13A illustrates an IC substrate 131 that includes a circuit board with 1FCO and 2F layer signal routing 196 to signal bumps 173 and ground bumps 171. The IC substrate 131 includes a first PTH via 110-1 with an insulating material 133 and a first partial via pad 112-1 that extends 180 degrees or less around the circumference of the first PTH via 110-1. The first PTH via 110-1 has a first anti-pad region 101-1 with a first void area 1310-1, where the RoV is reduced compared to a traditional PTH with a via pad that extends around an entire circumference of the PTH via 110 (e.g., the first anti-pad region 101-1 and the first void area 1310-1 are approximately half compared to a traditional PTH). FIG. 13 A further illustrates a second PTH via 110-2 with an insulating material 133 and a second partial via pad 112-2 that extends 90 degrees or less around the circumference of the second PTH via 110-2. The second PTH via 110-2 has a second anti-pad region 101-2 with a second void area 1310-2, where the RoV is reduced compared to a traditional PTH (e.g., the second anti-pad region 101-2 and the second void area 1310-2 are approximately one-fourth compared to a traditional PTH).

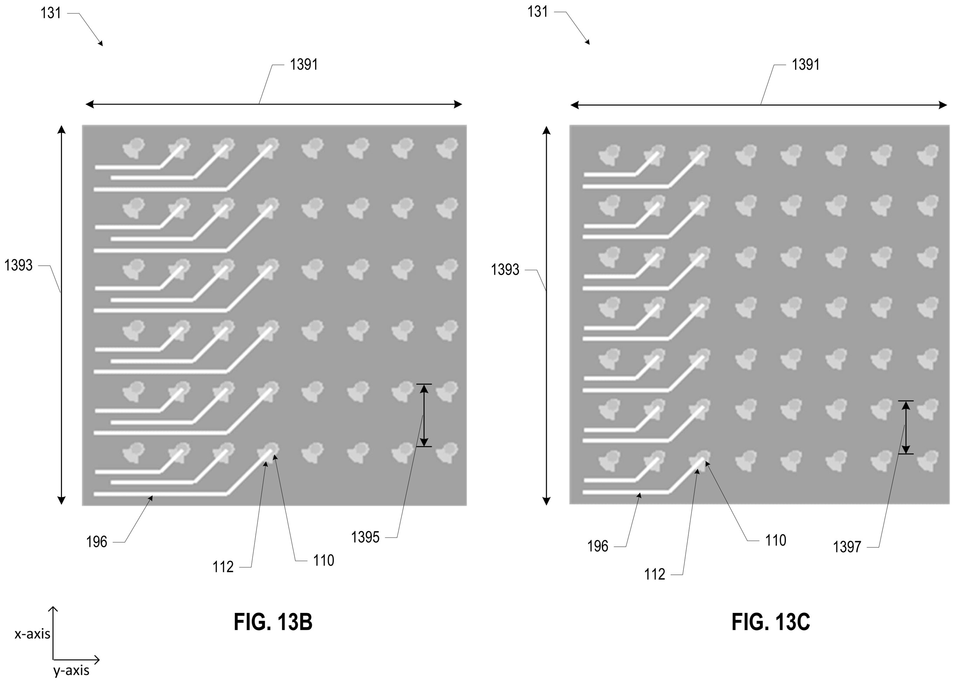

FIGS. 13B and 13C are top views of a portion of an IC substrate having PTH vias with partial via pads arranged in grid arrays, in accordance with various embodiments. FIG. 13B and 13C illustrate a portion of an IC substrate 131 that is a circuit board having a width 1391 equal to 5 millimeters (e.g., y-dimension) and a length 1393 equal to 5 millimeters (e.g., x-dimension) and including a grid array of PTH vias 110 with partial via pads 112 and signal traces 196. In particular, FIG. 13B illustrates a 5 millimeter by 5 millimeter portion of a circuit board having a grid array of 8 PTH vias 110 by 6 PTH vias 110 (e.g., 48 PTH vias 110), where PTH vias 110 have a gap 1395 (e.g., x-dimension) of approximately 600 microns and eighteen (18) signal traces 196 may be broken out. FIG. 13C illustrates a same 5 millimeter by 5 millimeter portion of a circuit board having a grid array of 8 PTH vias 110 by 7 PTH vias 110 (e.g., 56 PTH vias 110), where PTH vias 110 have a gap 1397 (e.g., x-dimension) of approximately 438 microns and fourteen (14) signal traces 196 may be broken out. FIGS. 13B and 13C illustrate that a PTH via 110 with a partial via pad 112 increases PTH via density and/or signal density in a circuit board. Generally, a same 5 millimeter by 5 millimeter portion of a circuit board having a grid array of traditional PTH vias may include 48 PTH vias with a gap of approximately 438 microns and twelve (12) signal traces may be broken out.

FIG. 14 is a perspective view of an example pair of PTH vias having partial via pads in an IC substrate, in accordance with various embodiments. An IC substrate 131 having a pair of partial PTH vias 115 extending between a first surface 170-1 and an opposing second surface 170-2 with a physical separation (e.g., air gap) between pair of partial PTH vias 115. The pair of partial PTH vias 115 may include a ground via 115A and a signal via 115B. In particular, a pair of partial PTH vias 115 may include a first partial PTH via 115A and a second partial PTH via 115B. A first partial PTH via 115A may have a first circumference 117A that is less than 360 degrees, a partial via pad 112A coupled to the first partial PTH 115A at the first surface 170-1 and the second surface 170-2, and a ground plane 196A coupled to the partial via pad 112A at the respective first and second surfaces 170-1, 170-2. A second partial PTH via 115B may have a second circumference 117B that is less than 360 degrees, a partial via pad 112B coupled to the second partial PTH via 115B at the first surface 170-1 and the second surface 170-2, and a signal trace 196B coupled to the partial via pad 112B at the respective first and second surfaces 170-1, 170-2. In some embodiments, the first partial PTH via 115A and the first partial via pad 112A are mirror images of the second partial PTH via 115B and the second partial via pad 112B.

The pair of partial PTH vias 115 also may be described herein as through hole 116 that extends from the first surface 170-1 to the second surface 170-2. The through hole 116 may have a first sidewall portion 117A and a second sidewall portion 117B opposite the first sidewall portion 117A, a first conductive material 115A extending between the first surface 170-1 and the second surface 170-2 on the first sidewall portion 117A, a first partial via pad 112A at the first surface 170-1 coupled to the first conductive material 115A, a second conductive material 115B extending between the first surface 170-1 and the second surface 170-2 on the second sidewall portion 117B; and a second partial via pad 112B at the first surface 170-1 coupled to the second conductive material 115B, wherein the first conductive material 115A and the first partial via pad 112A are physically separated from the second conductive material 115B and the second partial via pad 112B. In some embodiments, wherein the first conductive material 115A and the second conductive material 115B have semi-circular-shaped cross-sections.

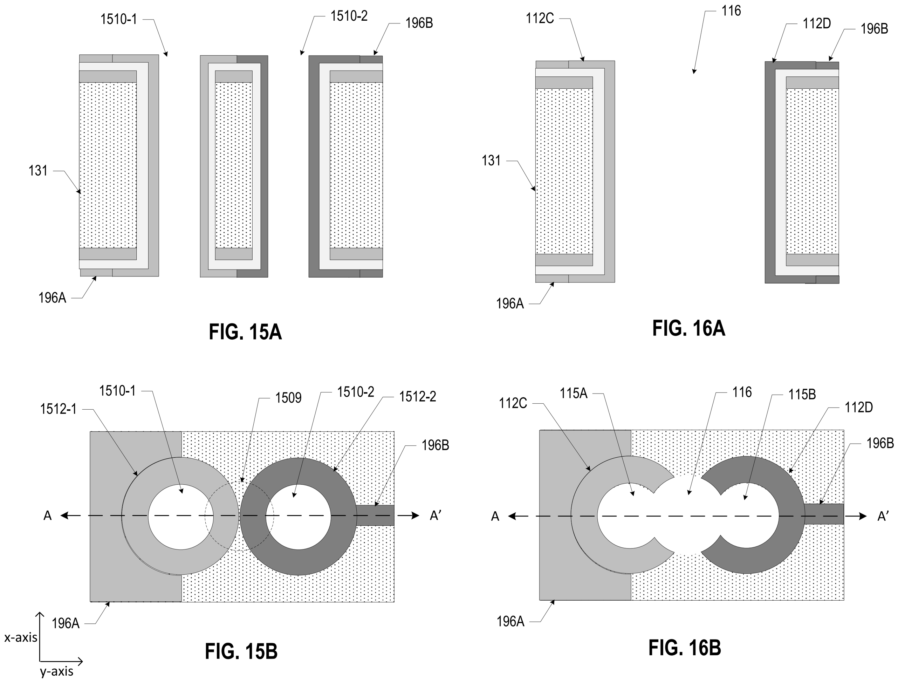

FIGS. 15A and 16A are side, cross-sectional views and FIGS. 15B and 16B are top views of an example method of fabricating an example pair of PTH vias having partial via pads in an IC substrate, in accordance with various embodiments. FIGS. 15B and 16B include cross-section A-A' as shown in FIG. 14. FIGS. 15A and 15B illustrate an assembly including an IC substrate 131 with a first PTH via 1510-1 with a first complete via pad 1512-1 coupled to a plane 196A and a second PTH via 1510-2 with a second complete via pad 1512-2 coupled to a signal trace 196B. The first PTH via 1510-1 and the second PTH via 1510-2 may be positioned with the first complete via pad 1512-1 touching or almost touching the second complete via pad 1512-2. The assembly of FIGS. 15A and 15B may be manufacturing using any suitable technique, such as described above with reference to FIGS. 4-7 and 9-11 (e.g., omitting FIG. 8). The assembly of FIG. 15B further indicates a drill area 1509. FIGS. 16A and 16B illustrate an assembly subsequent to forming a through hole 116 in the drill area 1509 in the assembly of FIG. 15B. The through hole 116 may be formed using any suitable technique, such as mechanical drilling. The through hole 116 may remove portions of the first PTH via 1510-1 with a first complete via pad 1512-1 and the second PTH via 1510-2 with a second complete via pad 1512-2 of the assembly of FIG. 15 to form a first partial PTH via 115A with a partial via pad 112C and a second partial PTH via 115B with a second partial via pad 112D.

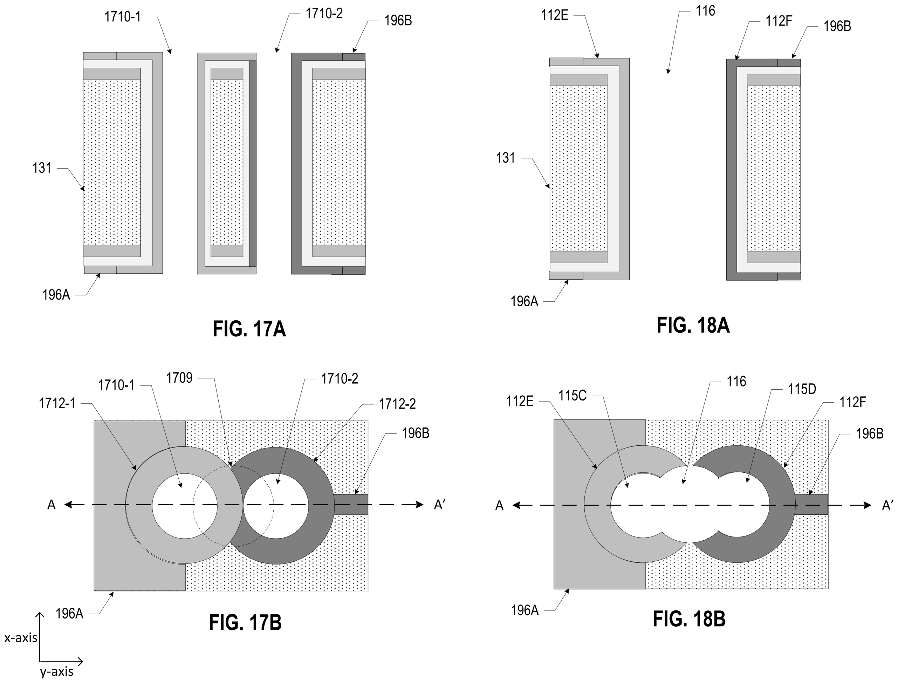

FIGS. 17A and 18A are side, cross-sectional views and FIGS. 17B and 18B are top views of an example method of fabricating another example pair of PTH vias having partial via pads in an IC substrate, in accordance with various embodiments. FIGS. 17B and 18B include cross-section A-A' as shown in FIG. 14. FIGS. 17A and 17B illustrate an assembly including an IC substrate 131 with a first PTH via 1710-1 with a first complete via pad 1712-1 coupled to a plane 196A and a second PTH via 1710-2 with a second complete via pad 1712-2 coupled to a signal trace 196B. The first PTH via 1710-1 and the second PTH via 1710-2 may be positioned with the first complete via pad 1712-1 overlapping the second complete via pad 1712-2. The assembly of FIGS. 17A and 17B may be manufacturing using any suitable technique, such as described above with reference to FIGS. 4-7 and 9-11 (e.g., omitting FIG. 8). The assembly of FIG. 17B further indicates a drill area 1709. FIGS. 18A and 18B illustrate an assembly subsequent to forming a through hole 116 in the drill area 1709 in the assembly of FIG. 17B. The through hole 116 may be formed using any suitable technique, such as mechanical drilling. The through hole 116 may remove portions of the first PTH via 1710-1 with a first complete via pad 1712-1 and the second PTH via 1710-2 with a second complete via pad 1712-2 of the assembly of FIG. 17 to form a first partial PTH via 115C with a partial via pad 112E and a second partial PTH via 115D with a second partial via pad 112F.

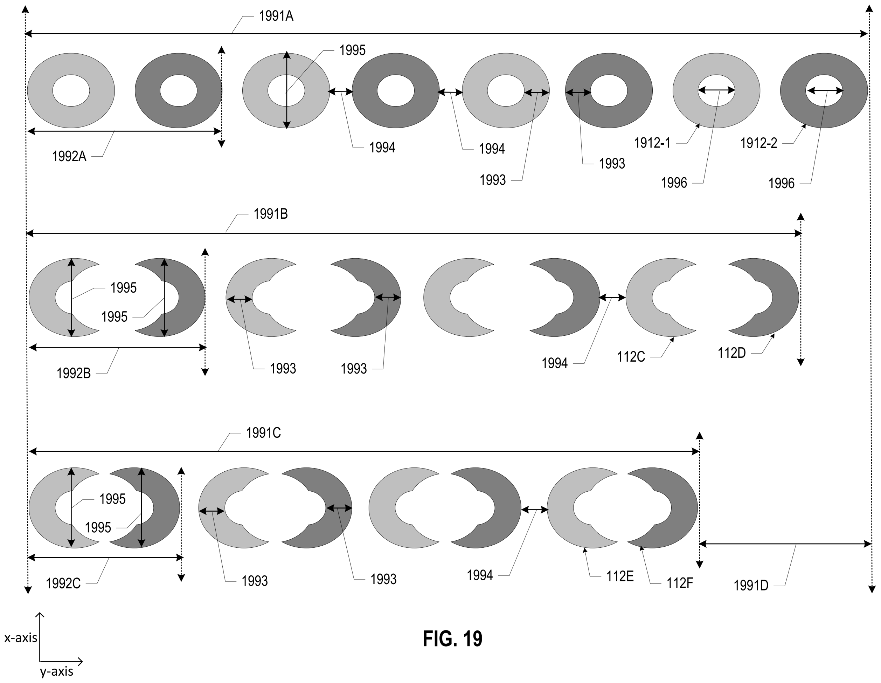

FIG. 19 illustrates a top view of paired PTH vias and associated spacing requirements in an IC substrate, in accordance with various embodiments. FIG. 19 is a schematic drawing of rows of four pairs of 1:1 ground to signal PTH vias (e.g., one nibble, four data bits). A first row shows traditional PTH vias with complete via pads 1912-1, 1912-2, a second row shows partial PTH vias with partial via pads 112C, 112D positioned as shown in FIG. 15B, and a third row shows partial PTH vias with partial via pads 112E, 112F positioned as shown in FIG. 17B. A diameter 1995 is measured by a straight line that passes through a center of a circle and connects two points on its boundary and is the longest distance across a circle. In some embodiments, a diameter 1995 is between 120 microns and 450 microns (e.g., between 120 microns and 300 microns). In some embodiments, a PTH via may have an opening 1996 (e.g., through hole) between 100 microns and 300 microns. In some embodiments, via pads 1912-1, 1912-2, 112C, 112D, 112E, 112F may have a width 1993 between 10 microns and 50 microns (e.g., between 10 microns and 25 microns). In some embodiments, a space 1994 between via pads 1912-1, 1912-2, or between pairs of via pads 112C, 112D and 112E, 112F, may be between 100 microns and 150 microns (e.g., approximately 125 microns). The first row shows traditional PTH vias with complete via pads 1912-1, 1912-2 having a space 1994 between each complete via pad 1912-1, 1912-2. A pair of traditional PTH vias with complete via pads 1912-1, 1912-2 have an overall width 1992A, and four pairs of traditional PTH vias with complete via pads 1912-1, 1912-2 have an overall width 1991A. The second row shows partial PTH vias with pairs of partial via pads 112C, 112D positioned as shown in FIG. 15B, where a pair of partial via pads 112C, 112D have an overall width 1992B (e.g., outside edge of partial via pad 112C to outside edge of partial via pad 112D) and four pairs of partial via pads 112C, 112D have an overall width 1991B. A width 1992B is equal to a sum of the diameters 1995 of the partial via pads 112C, 112D. The third row shows partial PTH vias with pairs of partial via pads 112E, 112F positioned as shown in FIG. 17B, where a pair of partial via pads 112E, 112F have a width 1992C (e.g., outside edge of partial via pad 112E to outside edge of partial via pad 112F) and four pairs of partial via pads 112E, 112F have an overall width 1991C. A width 1992C is less than a sum of the diameters 1995 of the partial via pads 112E, 112F. Using the following dimensions as an example, a space 1994 equals 125 microns, a diameter 1995 equals 450 microns, a width 1992A equals 1025 microns, a width 1992B equals 900 microns, and a width 1992C equals 775 microns, a width 1991D (e.g., width 1991A minus width 1991C) of 1000 microns may be saved.

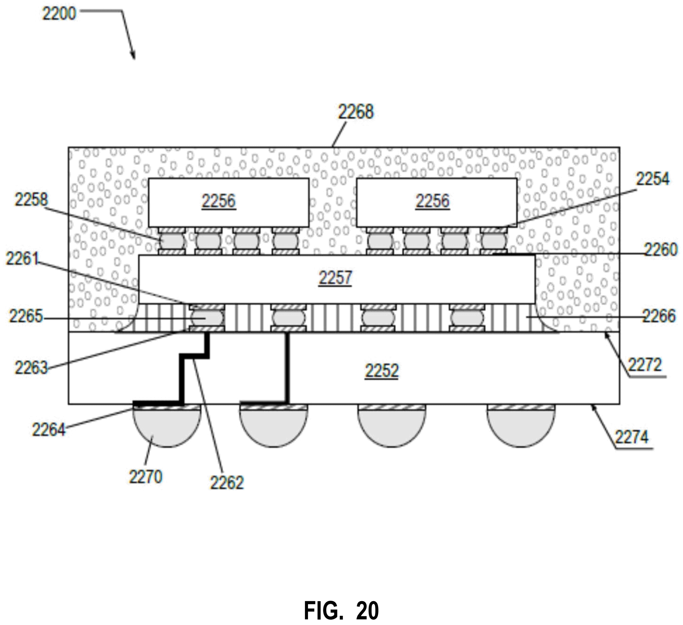

The electronic assemblies disclosed herein, e.g., any of the embodiments shown in FIGS. 1-19 or any further embodiments described herein, may be included in any suitable electronic component. FIGS. 20-22 illustrate various examples of packages, assemblies, and devices that may be used with or include any of the IC substrates as disclosed herein.

FIG. 20 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures including lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

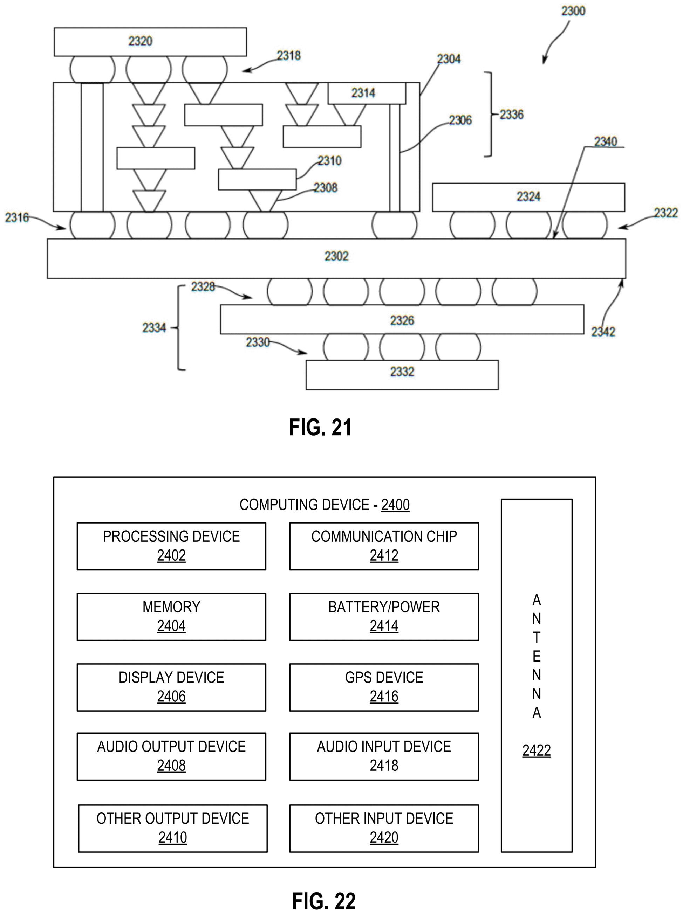

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 21.

In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 21 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 20.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 20.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2310 and vias 2308, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 22 is a block diagram of an example computing device 2400 that may include one or more components having one or more IC packages in accordance with any of the embodiments disclosed herein. For example, any suitable ones of the components of computing device 2400 may include a microelectronic assembly 100 in accordance with any of the embodiments disclosed herein. In another example, any one or more of the components of computing device 2400 may include any embodiments of IC package 2200 (e.g., as shown in FIG. 20). In yet another example, any one or more of the components of computing device 2400 may include an IC device assembly 2300 (e.g., as shown in FIG. 21).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 provides an integrated circuit (IC) substrate, including a first surface and an opposing second surface; a through hole extending from the first surface to the second surface, the through hole having a first sidewall portion and a second sidewall portion opposite the first sidewall portion; a first conductive material, extending between the first surface and the second surface, on the first sidewall portion; a second conductive material, extending between the first surface and the second surface, on the second sidewall portion; a third conductive material, at the first surface, coupled to the first conductive material in the through hole and extending outwards from the through hole; and a fourth conductive material, at the first surface, coupled to the second conductive material in the through hole and extending outwards from the through hole, where the first conductive material and the third conductive material are physically separated from the second conductive material and the fourth conductive material.

Example 2 provides the IC substrate of example 1, where the first conductive material and the third conductive material are physically separated from the second conductive material and the fourth conductive material by an air gap.

Example 3 provides the IC substrate of example 1 or 2, further including a signal trace coupled to the third conductive material; and a ground plane coupled to the fourth conductive material.

Example 4 provides the IC substrate of any one of examples 1-3, further including a fifth conductive material, at the second surface, coupled to the first conductive material in the through hole and extending outwards from the through hole; and a sixth conductive material, at the second surface, coupled to the second conductive material in the through hole and extending outwards from the through hole, where the fifth conductive material is physically separated from the sixth conductive material.

Example 5 provides the IC substrate of example 4, further including a first signal trace coupled to the third conductive material; a second signal trace coupled to the fifth conductive material; a first ground plane coupled to the fourth conductive material; and a second ground plane coupled to the sixth conductive material.

Example 6 provides the IC substrate of any one of examples 1-5, where the first conductive material and the second conductive material have semi-circular-shaped cross-sections.

Example 7 provides a printed circuit board, including a first surface and an opposing second surface; a first plated through hole (PTH) via extending from the first surface to the second surface, the first PTH via having a first circumference of less than 360 degrees; a first via pad, at the first surface, coupled to the first PTH via, where the first via pad extends around the first circumference of the first PTH via; a second PTH via, adjacent to the first PTH, extending from the first surface to the second surface, the second PTH via having a second circumference of less than 360 degrees; and a second via pad, at the first surface, coupled to the second PTH via, where the second via pad extends around the second circumference of the second PTH via, where the first PTH via and first via pad are physically separated from the second PTH via and the second via pad.

Example 8 provides the printed circuit board of example 7, where the first PTH via and first via pad are physically separated from the second PTH via and the second via pad by an air gap.

Example 9 provides the printed circuit board of example 7 or 8, further including a signal trace coupled to the first via pad; and a ground plane coupled to the second via pad.

Example 10 provides the printed circuit board of any one of examples 7-9, where the first PTH via is one of a plurality of first PTH vias and the second PTH via is one of a plurality of second PTH vias.

Example 11 provides the printed circuit board of any one of examples 7-10, where the first via pad has a first diameter, the second via pad has a second diameter, and a width, measured outside edge to outside edge, of the first via pad and the second via pad is equal to or less than a sum of the first diameter and the second diameter.

Example 12 provides the printed circuit board of any one of examples 7-11, further including a third via pad, at the second surface, coupled to the first PTH via, where the third via pad extends around the first circumference of the first PTH via; and a fourth via pad, at the second surface, coupled to the second PTH via, where the fourth via pad extends around the second circumference of the first PTH via.

Example 13 provides the printed circuit board of example 12, further including a first signal trace coupled to the first via pad; a second signal trace coupled to the third via pad; a first ground plane coupled to the second via pad; and a second ground plane coupled to the fourth via pad.

Example 14 provides the printed circuit board of any one of examples 7-13, where the first PTH via and the first via pad are mirror images of the second PTH via and the second via pad.

Example 15 provides an electronic assembly, including an integrated circuit (IC) substrate, having a first surface and an opposing second surface, including a pair of plated through hole (PTH) vias extending from the first surface to the second surface, the pair of PTH vias including a first PTH via having a first circumference of less than 360 degrees; a first via pad, at the first surface, coupled to the first PTH via, where the first via pad extends around the first circumference of the first PTH via; a second PTH via, adjacent to the first PTH via, having a second circumference of less than 360 degrees; and a second via pad, at the first surface, coupled to the second PTH via, where the second via pad extends around the second circumference of the second PTH via, where the first PTH via and first via pad are physically separated from the second PTH via and the second via pad; and a semiconductor device coupled to the first surface of the IC substrate.

Example 16 provides the electronic assembly of example 15, where the first PTH via and first via pad are physically separated from the second PTH via and the second via pad by an air gap.

Example 17 provides the electronic assembly of example 15 or 16, where the IC substrate further includes a signal trace coupled to the first via pad; and a ground plane coupled to the second via pad.

Example 18 provides the electronic assembly of any one of examples 15-17, where the pair of PTH vias are one of a plurality of pairs of PTH vias.

Example 19 provides the electronic assembly of any one of examples 15-18, where the first via pad has a first diameter, the second via pad has a second diameter, and a width, measured outside edge to outside edge, of the first via pad and the second via pad is equal to or less than a sum of the first diameter and the second diameter.

Example 20 provides the electronic assembly of any one of examples 15-19, where the IC substrate further includes a third via pad, at the second surface, coupled to the first PTH via, where the third via pad extends around the first circumference of the first PTH via; and a fourth via pad, at the second surface, coupled to the second PTH via, where the fourth via pad extends around the second circumference of the first PTH via.

Example 21 provides the electronic assembly of example 20, where the IC substrate further includes a first signal trace coupled to the first via pad; a second signal trace coupled to the third via pad; a first ground plane coupled to the second via pad; and a second ground plane coupled to the fourth via pad.

Example 22 provides the electronic assembly of any one of examples 15-21, where the first PTH via and the first via pad are mirror images of the second PTH via and the second via pad.

Example 23 provides the electronic assembly of any one of examples 15-22, where the IC substrate includes a printed circuit board.

Example 24 provides the electronic assembly of any one of examples 15-23, where the IC substrate includes a package substrate.

Example 25 provides the electronic assembly of any one of examples 15-24, where the first surface is a first major surface of the IC substrate and the second surface is a second major surface of the IC substrate.

Example 26 provides the electronic assembly of any one of examples 15-25, where the IC substrate includes a plurality of layers and the first surface is a surface of an internal layer of the plurality of layers.

Example 27 provides the electronic assembly of any one of examples 15-26, where the IC substrate includes a plurality of layers, and the first surface is a first surface of an internal layer of the plurality of layers and the second surface is a second surface, opposite the first surface, of the internal layer.

Example 28 provides the electronic assembly of any one of examples 15-27, where the IC substrate includes a plurality of layers, and the first surface is a surface of an internal layer of the plurality of layers and the second surface is a surface of another internal layer of the plurality of layers.

## Claims

1. An integrated circuit (IC) substrate, comprising:
a first surface and an opposing second surface;
a through hole extending from the first surface to the second surface, the through hole having a first sidewall portion and a second sidewall portion opposite the first sidewall portion;
a first conductive material, extending between the first surface and the second surface, on the first sidewall portion;
a second conductive material, extending between the first surface and the second surface, on the second sidewall portion;
a third conductive material, at the first surface, coupled to the first conductive material in the through hole and extending outwards from the through hole; and
a fourth conductive material, at the first surface, coupled to the second conductive material in the through hole and extending outwards from the through hole, wherein the first conductive material and the third conductive material are physically separated from the second conductive material and the fourth conductive material.

2. The IC substrate of claim 1, wherein the first conductive material and the third conductive material are physically separated from the second conductive material and the fourth conductive material by an air gap.

3. The IC substrate of claim 1 or 2, further comprising:
a signal trace coupled to the third conductive material; and
a ground plane coupled to the fourth conductive material.

4. The IC substrate of any one of claims 1-3, further comprising:
a fifth conductive material, at the second surface, coupled to the first conductive material in the through hole and extending outwards from the through hole; and
a sixth conductive material, at the second surface, coupled to the second conductive material in the through hole and extending outwards from the through hole, wherein the fifth conductive material is physically separated from the sixth conductive material.

5. The IC substrate of claim 4, further comprising:
a first signal trace coupled to the third conductive material;
a second signal trace coupled to the fifth conductive material;
a first ground plane coupled to the fourth conductive material; and
a second ground plane coupled to the sixth conductive material.

6. The IC substrate of any one of claims 1-5, wherein the first conductive material and the second conductive material have semi-circular-shaped cross-sections.

7. A printed circuit board, comprising:
a first surface and an opposing second surface;
a first plated through hole (PTH) via extending from the first surface to the second surface, the first PTH via having a first circumference of less than 360 degrees;
a first via pad, at the first surface, coupled to the first PTH via, wherein the first via pad extends around the first circumference of the first PTH via;
a second PTH via, adjacent to the first PTH via, extending from the first surface to the second surface, the second PTH via having a second circumference of less than 360 degrees; and
a second via pad, at the first surface, coupled to the second PTH via, wherein the second via pad extends around the second circumference of the second PTH via, wherein the first PTH via and first via pad are physically separated from the second PTH via and the second via pad.

8. The printed circuit board of claim 7, wherein the first PTH via and first via pad are physically separated from the second PTH via and the second via pad by an air gap.

9. The printed circuit board of claim 7 or 8, further comprising:
a signal trace coupled to the first via pad; and
a ground plane coupled to the second via pad.

10. The printed circuit board of any one of claims 7-9, wherein the first via pad has a first diameter, the second via pad has a second diameter, and a width, measured outside edge to outside edge, of the first via pad and the second via pad is equal to or less than a sum of the first diameter and the second diameter.

11. The printed circuit board of any one of claims 7-10, further comprising:
a third via pad, at the second surface, coupled to the first PTH via, wherein the third via pad extends around the first circumference of the first PTH via; and
a fourth via pad, at the second surface, coupled to the second PTH via, wherein the fourth via pad extends around the second circumference of the first PTH via.

12. The printed circuit board of claim 11, further comprising:
a first signal trace coupled to the first via pad;
a second signal trace coupled to the third via pad;
a first ground plane coupled to the second via pad; and
a second ground plane coupled to the fourth via pad.

13. The printed circuit board of any one of claims 7-12, wherein the first PTH via and the first via pad are mirror images of the second PTH via and the second via pad.

14. The printed circuit board of any one of claims 7-13, further comprising:
a semiconductor device coupled to the first surface of the printed circuit board.

15. The printed circuit board of any one of claims 7-14, wherein the first PTH via is one of a plurality of first PTH vias and the second PTH via is one of a plurality of second PTH vias.
